# FASCICULE DE BREVET EUROPEEN

(11) **EP 0 693 777 B1**
(45) Date de publication et mention de la délivrance du brevet: **27.09.2000**
(21) Numéro de dépôt: 95410072.3
(22) Date de dépôt: 20.07.1995
(51) Int. Cl.: H01L 23/31, H01L 21/56

(54) **Boîtier BGA à moulage par injection**
Spritzgegossene BGA-Packung
Injection moulded BGA-package

(30) Priorité: 21.07.1994 FR 9409251
(43) Date de publication de la demande: 24.01.1996
(73) Titulaire: STMicroelectronics S.A., 94250 Gentilly (FR)
(72) Inventeur: Exposito, Juan, F-38330 Saint Nazaire Les Eymes (FR)
(74) Mandataire: de Beaumont, Michel

(56) Documents cités:
- EP-A- 0 463 559
- US-A- 5 216 278
- PATENT ABSTRACTS OF JAPAN vol. 014 no. 396 (E-0970) ,27 Août 1990 & JP-A-02 150042 (NEC CORP) 8 Juin 1990,
- PATENT ABSTRACTS OF JAPAN vol. 018 no. 364 (E-1575) ,8 Juillet 1994 & JP-A-06 097666 (HITACHI LTD;OTHERS: 01) 8 Avril 1994,
- Patent Abstracts of Japan Vol. 6, No. 160 (E-126) 21 August 1992 & JP-A-57 079652 (TANIURA TAKASHI) 18 May 1982

## Description

La présente invention concerne un boîtier pour puce de circuit intégré. Elle s'applique plus particulièrement à la réalisation d'un boîtier, constitué à partir d'une plaquette isolante sur une surface supérieure de laquelle est montée une puce de circuit intégré qui est ensuite encapsulée. Des bornes sur une surface supérieure de la puce sont reliées à des plots de connexion sur la face supérieure de la plaquette. Une face inférieure de la plaquette comprend un réseau, de préférence régulier, de bossages ou billes conductrices de raccordement. Chaque bille est reliée à l'un des plots de connexion sur la face opposée de la plaquette par l'intermédiaire d'un trou métallisé. Ce type de boîtier est communément appelé un boîtier BGA (Ball Grid Array).

La plaquette isolante est par exemple du type utilisé pour former des cartes de circuit imprimé. Un problème dans ce type de boîtier réside dans la réalisation de l'encapsulation.

Un premier mode d'encapsulation consiste à déposer une goutte de résine époxy, qui se répand sur la puce et la plaquette, en étant limitée par une barrière constituée d'un cordon de résine époxy plus visqueuse. Un inconvénient que présente ce procédé réside dans l'absence de planéité de la surface du boîtier obtenu.

Un second mode d'encapsulation consiste à injecter de la résine époxy à partir d'un moule embrassant en face supérieure la plaquette portant la puce. Le boîtier obtenu présente un bon état de surface de résine époxy qui autorise son marquage.

Dans les deux cas, la résine époxy est chauffée pour provoquer sa solidification. Un inconvénient que l'on retrouve dans les deux types de boîtier est que la contraction de la résine époxy lors de son durcissement, provoque une déformation de la plaquette qui tend à la rendre concave vers la puce. Cette déformation peut provoquer une cassure de la puce de circuit intégré rendant le circuit inutilisable. Une solution actuelle à ce genre de problème consiste à augmenter l'épaisseur de la plaquette pour accroître sa résistance à la déformation. Cela conduit de plus à utiliser des plaquettes qui sont d'autant plus épaisses que la surface de la puce augmente.

Un autre inconvénient des boîtiers classiques est que l'interface entre la résine époxy et la plaquette supérieure constitue une voie de pénétration d'humidité dans le boîtier.

Un autre inconvénient des boîtiers classiques est que des pistes conductrices reliant, au moins en face supérieure, les plots de connexion aux trous métallisés s'étendent hors de la surface occupée par la résine époxy en raison de l'étendue du réseau de bille de raccordement en face inférieure de la plaquette. Pour isoler ces pistes, les procédés classiques de réalisation de tels boîtiers prévoient le dépôt d'une couche de résine photosensible isolante qui recouvre la face supérieure de la plaquette, avant montage de la puce, et qui est ouverte uniquement au droit des plots de connexion, qui sont eux situés sous la résine époxy.

De plus, les plaquettes sont généralement réalisées par un procédé collectif à partir de plaques de grandes dimensions, puis découpées. Certaines pistes conductrices s'étendent donc généralement jusqu'aux bords de la plaquette obtenue. Cela augmente les risques de pénétration d'humidité dans le boîtier en créant une voie de pénétration par les tranches de la plaquette.

Dans le document US-A-5 216 278, des vias métallisés sont formés dans une plaquette pour reporter des connexions entre les faces supérieure et inférieures de la puce. Ces vias, ainsi que des pistes conductrices les reliant à des plots de connexion à des bornes de la puce en face supérieure et à des billes de raccordement en face inférieure, sont recouverts d'une couche d'isolement avant encapsulation de la puce sans que le matériau d'encapsulation recouvre toute la face inférieure de la plaquette. Outre le fait qu'une telle structure laisse subsister un risque de déformation de la plaquette due à la contraction du matériau d'encapsulation lors de son durcissement, les vias piègent des bulles d'air lors de la formation des couches d'isolement qui, par dilatation, peuvent provoquer des cassures des couches d'isolement.

Le document EP-A-0 463 559 décrit une méthode d'encapsulation d'une puce de circuit intégré sur une plaquette qui est découpée après encapsulation.

Le document JP-A-57 079 652 décrit un boîtier pour circuit intégré dans lequel une puce de circuit intégré est déposée sur une face supérieure d'une plaquette isolante et est recouverte de résine, la surface inférieure de la plaquette comportant des plots de raccordement à l'aplomb de trous traversants métallisés de report de connexions entre les faces supérieure et inférieure de la plaquette.

L'invention vise à pallier aux inconvénients des boîtiers connus en proposant un boîtier BGA qui offre une bonne résistance à la déformation sans recourir à une augmentation de l'épaisseur de la plaquette.

L'invention vise également à proposer un boîtier BGA qui supprime toute voie de pénétration d'humidité dans le boîtier.

L'invention vise en outre à proposer un boîtier BGA qui évite le recours à une couche d'isolement des pistes conductrices de liaison entre les plots de raccordement et les trous métallisés.

Pour atteindre ces objets, la présente invention prévoit un boîtier de montage d'une puce de circuit intégré comportant une plaquette isolante, sur la face supérieure de laquelle est posée la puce, et dont la face inférieure comporte un réseau de billes de raccordement, chaque bille étant reliée à un premier plot de connexion à une borne de la puce disposée en face supérieure, par l'intermédiaire d'un trou traversant métallisé, de pistes conductrices et d'un second plot de connexion, la puce et la plaquette étant encapsulées dans une résine époxy recouvrant les tranches de la plaquette et présente sur toute sa face inférieure, entre les billes de raccordement, et recouvrant directement les pistes conductrices situées en faces supérieure et inférieure de la plaquette, lesdits trous métallisés étant remplis de résine époxy.

Selon un mode de réalisation de la présente invention, le boîtier comporte des trous traversants métallisés à l'aplomb de la puce.

Selon un mode de réalisation de la présente invention, lesdits trous métallisés situés à l'aplomb de la puce sont remplis, depuis la face supérieure, par une colle servant à fixer la puce sur la plaquette et, depuis la face inférieure, par ladite résine époxy, lesdites pistes conductrices situées en face supérieure de la plaquette et à l'aplomb de la puce étant directement recouvertes par ladite colle.

La présente invention concerne également un procédé de réalisation d'un boîtier de circuit intégré comprenant les étapes suivantes :
- prévoir une plaquette isolante pourvue de trous traversants métallisés de report de connexions entre des faces supérieure et inférieure de la plaquette, ladite face supérieure comprenant des premiers plots de connexion à des bornes d'une puce de circuit intégré, reliés audits trous par des premières pistes conductrices, et ladite face inférieure compre nant des seconds plots de connexion de billes de raccordement, reliés audits trous par des secondes pistes conductrices ;
- poser la puce de circuit intégré sur la face supérieure de la plaquette ;
- disposer la structure dans un moule d'injection de produit d'encapsulation ; et
- injecter du produit dans le moule de façon à encapsuler la puce et la plaquette, le moule étant formé de façon à recouvrir toute la face inférieure de la plaquette à l'exception de zones de réception des billes de raccordement, le matériau d'encapsulation recouvrant les tranches de la plaquette et recouvrant directement lesdites pistes conductrices situées en face supérieure de la plaquette et hors de l'aplomb de la puce, ainsi que lesdites pistes conductrices situées en face inférieure de la plaquette, et remplissant lesdits trous métallisés.

Selon un mode de réalisation de la présente invention, le procédé comprend les étapes suivantes :
- perçage de la plaquette aux emplacements futurs des trous métallisés ;
- dépôt d'une couche conductrice sur les deux faces de la plaquette, selon un motif de pistes et de plots de connexion reliés aux trous ;
- collage de la puce de circuit intégré en face supérieure de la plaquette, au moyen d'une couche de colle isolante ;
- réalisation des connexions de la puce aux premiers plots de la face supérieure de la plaquette, au moyen de fils conducteurs ;
- encapsulation sous une résine époxy par moulage avec définition de zones de dépôt des billes de raccordement au niveau des seconds plots, au moyen d'inserts dans le moule ; et
- dépôt de billes de raccordement en face inférieure de la plaquette, dans les ouvertures pratiquées dans la couche de résine époxy par les inserts au niveau des seconds plots.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 représente en coupe, un mode de réalisation d'un boîtier de montage d'une puce de circuit intégré selon l'invention ; et
les figures 2A à 2F illustrent différentes étapes d'un mode de mise en oeuvre d'un procédé de montage d'un circuit intégré selon l'invention.

Les représentations des figures ne sont pas à l'échelle pour des raisons de clarté.

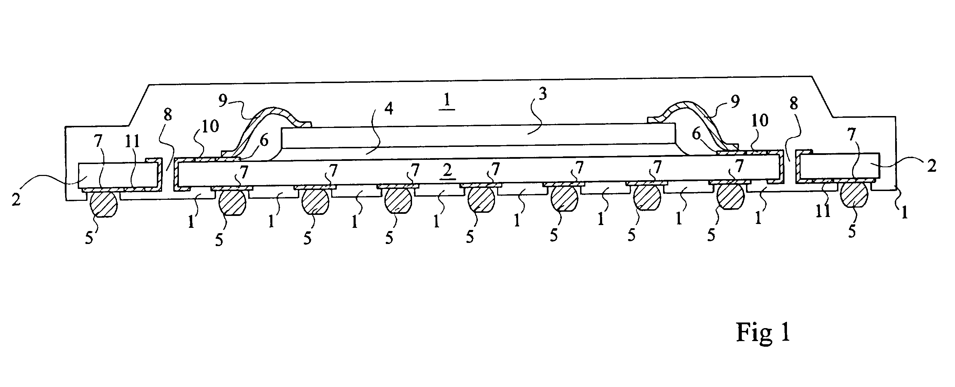

Comme le montre la figure 1, un boîtier selon l'invention se caractérise par un moulage de résine époxy 1 qui se prolonge, depuis la face supérieure d'une plaquette 2 recevant une puce 3 de circuit intégré, jusqu'au moins la périphérie de la face inférieure de cette plaquette 2. La puce 3 de circuit intégré est disposée sur la face supérieure de la plaquette 2 avec interposition d'une couche de collage 4.

Ainsi, les tranches de la plaquette 2 sont, selon l'invention, recouvertes de résine époxy 1.

Préférentiellement, les intervalles entre les billes 5, en face inférieure de la plaquette 2, sont également recouverts de résine époxy 1. L'épaisseur de la résine époxy 1, en face inférieure, est inférieure au diamètre des billes 5.

La liaison des billes de raccordement 5 à des bornes de la puce 3 s'effectue par l'intermédiaire de pistes conductrices 10, 11 et de plots de connexion 6 et 7 respectivement en face inférieure et supérieure de la plaquette 2, de trous métallisés 8 et de fils conducteurs 9. Chaque borne de la puce 3 est reliée, par l'intermédiaire d'un fil conducteur, à un plot de connexion 6. Chaque plot 6 est relié, par l'intermédiaire d'une piste conductrice 10 en face supérieure de la plaquette 2, à un trou métallisé 8. En face inférieure, chaque trou 8 est relié, par l'intermédiaire d'une piste conductrice 11, à un plot de connexion 7 d'une bille 5.

La présence de résine époxy 1 sur les deux faces de la plaquette 2 permet d'équilibrer les contraintes dues à la contraction de la résine époxy 1 lors de son durcissement. On réduit ainsi considérablement les risques de déformation du boîtier et de cassure de la puce 3. On peut de ce fait utiliser une plaquette 2 de faible épaisseur sans risquer de provoquer des cassures dans la puce 3 de circuit intégré.

De plus, les tranches de la plaquette 2 étant recouvertes par la résine époxy 1, on limite les risques de pénétration d'humidité dans le boîtier, ce qui améliore la fiabilité de ce dernier même si les pistes conductrices s'étendent jusqu'aux bords de la plaquette 2. En effet, on supprime toute possibilité de pénétration d'humidité par les tranches du boîtier.

En outre, comme la résine époxy 1 recouvre les intervalles entre les billes de raccordement 5, en face inférieure de la plaquette 2, on évite le recours à une couche de résine photosensible isolante sur cette face inférieure. Ceci améliore considérablement le montage en boîtier de puces de circuit intégré.

Classiquement, chacune des faces de la plaquette 2 est recouverte d'une couche de résine photosensible isolante et ouverte aux emplacements des plots, respectivement 6 et 7. Cette couche de résine photosensible qui est déposée sur les faces de la plaquette 2 ne comble pas les trous métallisés 8 qui traversent la plaquette 2. Cela entraîne la formation de bulles d'air qui sont prisonnières entre les deux couches de résine photosensible. La présence de ces bulles est néfaste. En effet, ces bulles se dilatent, sous l'effet de la chaleur à laquelle le boîtier est soumis dans la suite du processus d'encapsulation ou lors de l'utilisation du circuit intégré. Elles risquent alors de provoquer des cassures de la couche de résine photosensible. Ces risques de cassures entraînent que l'on ne peut, dans les boîtiers classiques, placer de trous métallisés 8 à l'aplomb de la puce 3. En effet, l'apparition de cassures pourrait endommager la puce elle-même. De telles cassures sont également préjudiciables à l'isolement de la face inférieure de la plaquette 2.

L'invention permet d'éviter le recours à la couche de résine photosensible en face inférieure en faisant remplir sa fonction d'isolement par la résine époxy 1. La résine époxy 1 étant plus fluide que les résines photosensibles usuelles et étant moulée par injection sous haute pression, elle pénètre complètement dans les trous 8. On supprime ainsi l'emprisonnement de bulles d'air dans les trous métallisés 8, et on autorise l'apposition de billes de raccordement 5, en face inférieure de la plaquette 2, à l'aplomb de la puce 3.

Un autre avantage de recouvrir les intervalles entre les billes de raccordement 5 et de remplir les trous métallisés 8 de résine époxy 1 est que cela supprime toute voie de pénétration d'humidité dans le boîtier.

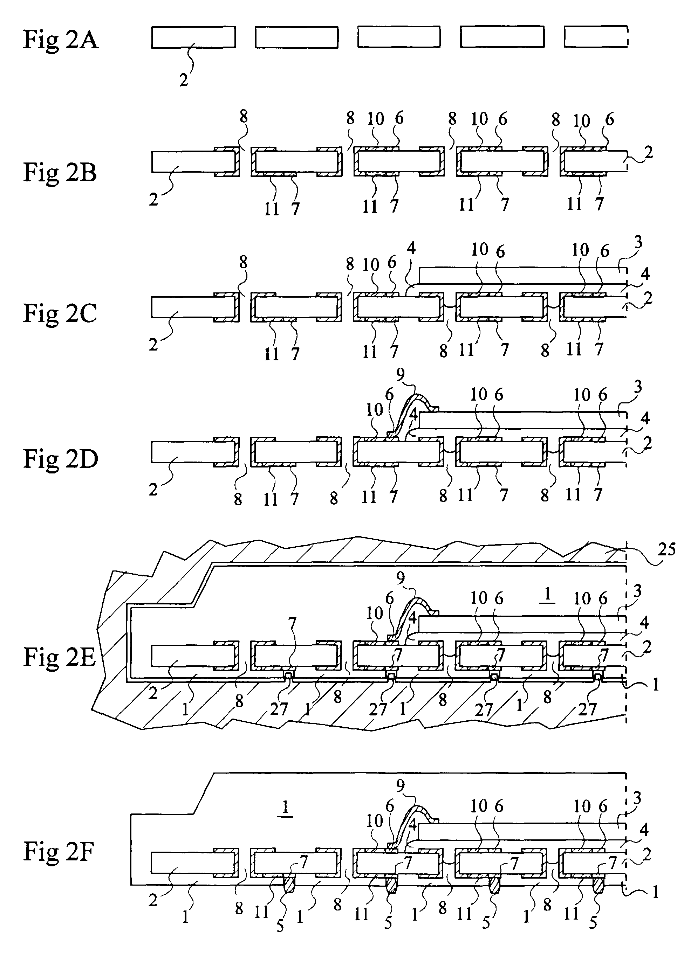

On décrira ci-après un exemple de mode de mise en oeuvre d'un procédé de montage de circuit intégré selon l'invention. Cet exemple est décrit en relation avec les figures 2A à 2F. Ces figures représentent, partiellement et en coupe, la structure du boîtier selon l'invention à différentes étapes du procédé.

Dans une première étape (figure 2A), on perce la plaquette isolante 2 aux emplacements futurs des trous métallisés.

Dans une deuxième étape (figure 2B), on réalise un dépôt chimique conducteur, par exemple de cuivre, sur les deux faces de la plaquette 2 de façon à créer des trous métallisés 8 ainsi que des pistes conductrices 10, 11 et des premiers 6 et seconds 7 plots de connexion, respectivement en face supérieure et inférieure de la plaquette 2.

Dans une troisième étape (figure 2C), la puce 3 est collée au moyen d'une couche de colle isolante 4. La colle pénètre dans les trous métallisés 8 qui sont en dessous de la puce 3, sous l'effet de la pression exercée sur la puce 3. On favorise ainsi l'accrochage de la couche de colle 4 tout en évitant la formation de bulles d'air dans les trous 8.

Dans une quatrième étape (figure 2D), on réalise les connexions entre les premiers plots 6 de la face supérieure et les bornes de la puce 1 au moyen de fils conducteurs 9, par exemple de fils d'or. Compte tenu du plan de coupe des figures, un seul fil 9 est représenté. En pratique, des fils 9 seront présents sur tous les cotés de la puce 1.

Puis on encapsule l'ensemble dans une résine époxy 1 au cours d'une cinquième étape (figure 2E). Cette encapsulation est réalisée par injection de résine époxy 1 dans un moule. Ce moule (non représenté) présente des inserts métalliques définissant, en face inférieure, les emplacements futurs des billes de raccordement 5. La résine époxy 1 qui est injectée sous pression pénètre complètement dans les trous 8, ce qui outre la suppression de bulles d'air, améliore l'ancrage de la résine époxy 1 sur la plaquette 2 et ainsi la fiabilité du boîtier.

Enfin, dans une sixième et dernière étape, on dépose des billes 5 sur les seconds plots 7 de la face inférieure de la plaquette 2, aux emplacements où les inserts du moule ont empêché le dépôt de résine époxy 1. On obtient ainsi un boîtier tel que celui représenté à la figure 1.

La présence de résine époxy 1 dans les intervalles entre les billes de raccordement 5, en face inférieure de la plaquette 2 facilite le placement des billes de raccordement 5. En effet, la résine époxy 1 sert alors de guide pour le positionnement des billes 5 aux emplacements où les inserts du moule ont empêché le dépôt de résine époxy 1.

De plus, cela évite tout risque de décollement ultérieur des billes de raccordement 5. En effet, dans un boîtier classique, les billes risquent de se décoller des plots de connexion 7 sous l'effet de contraintes thermomécaniques auxquelles est soumis le boîtier lors de son montage final sur une carte de circuit imprimé. L'invention permet de tirer profit de la fusion à laquelle sont soumises les billes 5 lors du montage final du boîtier, pour les encastrer dans la résine époxy 1 ce qui améliore considérablement leur tenue mécanique.

Afin d'améliorer les contacts entre, respectivement, les fils 9 ou les billes 5, et leurs plots de connexion respectifs 6 ou 7, on peut effectuer un dépôt électrolytique conducteur (non représenté) sur les deux faces de la plaquette 2, au cours d'une étape intermédiaire aux deuxième et troisième étapes. Ce dépôt est, par exemple, constitué de nickel et d'or. Il est présent, en face inférieure sur les seconds plots 7 et, en face supérieure sur les premiers plots 6 et les trous métallisés 8.

Comme on vient de le voir, l'invention permet de supprimer complètement le recours à une couche de résine photosensible isolante, même en face supérieure de la plaquette 2. Ce résultat est atteint en prévoyant un recouvrement complet de la face supérieure de la plaquette 2 par la résine époxy 1 d'encapsulation. Ainsi, non seulement on améliore considérablement la fiabilité du boîtier obtenu, en évitant tout risque de cassure de la puce 3 tout en autorisant le recours à une plaquette 2 de faible épaisseur. Mais on permet également de réduire la surface de plaquette 2 nécessaire en autorisant l'apposition de billes de raccordement 5 à l'aplomb de la puce 3. On simplifie en outre le processus d'encapsulation en évitant une étape de dépôt et de gravure d'une couche de résine photosensible.

Bien entendu, la présente invention est susceptible de diverses variantes et modifications qui apparaîtront à l'homme de l'art. En particulier, chacun des constituants décrits pour les couches pourra être remplacé par un ou plusieurs constituants présentant les mêmes caractéristiques et/ou remplissant la même fonction. On pourra par exemple, maintenir l'emploi d'une couche de résine photosensible d'isolement en face inférieure, la résine époxy recouvrant tout ou partie de la face inférieure de la plaquette 2. Dans ce cas la couche de résine photosensible sera gravée aux emplacements futurs des billes de raccordement 5. De même, la succession des étapes donnée à titre d'exemple peut être modifiée selon les matériaux et moyens de dépôt et/ou gravure utilisés.

De plus, bien que dans l'exemple décrit, le boîtier soit appliqué à une plaquette 2 pourvue de billes 5 de raccordement sur sa face inférieure, l'invention s'applique à tout type de boîtiers du type comportant une plaquette isolante revêtue d'un matériau d'encapsulation, et des plots de raccordement en face inférieure. Par exemple, la plaquette peut être multicouches et dépourvue de trous traversant, des plots de raccordement en face inférieure, étant reliés à des plots en face supérieure, par l'intermédiaire de pistes réalisées dans des couches conductrices entre lesquelles sont interposées des couches isolantes. Dans ce cas, la suppression de la voie de pénétration d'humidité par les tranches de la plaquette constitue un avantage encore plus sensible dans la mesure où la réalisation de la plaquette impose une structure multicouches qui augmente les risques de pénétration d'humidité par ses tranches.

En outre, l'invention s'applique à toute forme de boîtier, qu'elle soit carrée, rectangulaire, ronde, ovale, etc..

## Revendications

1. Boîtier de montage d'une puce (3) de circuit intégré comportant une plaquette isolante (2), sur la face supérieure de laquelle est posée la puce, et dont la face inférieure comporte un réseau de billes (5) de raccordement, chaque bille étant reliée à un premier plot (6) de connexion à une borne de la puce disposée en face supérieure, au moyen d'un trou traversant métallisé (8), de pistes conductrices (10, 11) et d'un second plot de connexion (7), la puce (3) et la plaquette (2) étant encapsulées dans une résine époxy (1), caractérisé en ce que la résine recouvre les tranches de la plaquette et est présente sur toute sa face inférieure, entre les billes (5) de raccordement, et recouvre directement les pistes conductrices (10, 11) situées en faces supérieure et inférieure de la plaquette, et en ce que lesdits trous métallisés (8) sont remplis de résine époxy (1).

2. Boîtier de montage d'une puce de circuit intégré selon la revendication 1, caractérisé en ce qu'il comporte des trous traversants métallisés (8) à l'aplomb de la puce (3).

3. Boîtier de montage d'une puce de circuit intégré selon la revendication 2, caractérisé en ce que lesdits trous métallisés (8) situés à l'aplomb de la puce (3) sont remplis, depuis la face supérieure, par une colle (4) servant à fixer la puce (3) sur la plaquette (2) et, depuis la face inférieure, par ladite résine époxy (1), lesdites pistes conductrices (10) situées en face supérieure de la plaquette (2) et à l'aplomb de la puce (3) étant directement recouvertes par ladite colle (4).

4. Procédé de réalisation d'un boîtier de circuit intégré comprenant les étapes suivantes :
- prévoir une plaquette isolante (2) pourvue de trous traversants métallisés (8) de report de connexions entre des faces supérieure et inférieure de la plaquette, la face supérieure comprenant des premiers plots (6) de connexion à des bornes d'une puce (3) de circuit intégré, reliés audits trous par des premières pistes conductrices (10), et la face inférieure comprenant des seconds plots (7) de connexion de billes de raccordement (5), reliés audits trous par des secondes pistes conductrices (11) ;
- poser la puce (3) de circuit intégré sur la face supérieure de la plaquette (2) ;
- disposer la structure dans un moule d'injection de produit d'encapsulation (1) ; et
- injecter du produit dans le moule de façon à encapsuler la puce (3) et la plaquette (2),
caractérisé en ce que le moule est formé de façon à recouvrir toute la face inférieure de la plaquette (2) à l'exception de zones de réception des billes de raccordement (5), le matériau d'encapsulation (1) recouvrant les tranches de la plaquette et recouvrant directement les pistes conductrices (10) situées en face supérieure de la plaquette et hors de l'aplomb de la puce, ainsi que les pistes conductrices (11) situées en face inférieure de la plaquette, et remplissant lesdits trous métallisés.

5. Procédé de réalisation d'un boîtier de circuit intégré selon la revendication 4, caractérisé en ce qu'il comprend les étapes suivantes :
- perçage de la plaquette (2) aux emplacements futurs des trous métallisés (8) ;
- dépôt d'une couche conductrice sur les deux faces de la plaquette (2), selon un motif de pistes (10, 11) et de plots de connexion (6, 7) reliés aux trous (8) ;
- collage de la puce (3) de circuit intégré en face supérieure de la plaquette (2), au moyen d'une couche de colle isolante (4) ;
- réalisation des connexions de la puce (3) aux premiers plots (6) de la face supérieure de la plaquette (2), au moyen de fils conducteurs (9) ;
- encapsulation sous une résine époxy (1) par moulage avec définition de zones de dépôt des billes de raccordement (5) au niveau des seconds plots (7), au moyen d'inserts dans le moule ; et
- dépôt de billes de raccordement (5) en face inférieure de la plaquette (2), dans les ouvertures pratiquées dans la couche de résine époxy (1) par les inserts au niveau des seconds plots (7).

## Patentansprüche

1. Montagegehäuse für einen integrierten Schaltungschip (3), mit einem isolierenden Plättchen (2), auf dessen Oberseite der Chip angeordnet ist, und das auf seiner Unterseite ein Netz bzw. Gitter von Anschlußverbindungs-Kügelchen (5) aufweist, wobei jeweils jedes Kügelchen mit einem ersten Anschlußkissen-bzw. -fleck zur Verbindung mit einem Anschluß des auf der Oberseite angeordneten Chips verbunden ist, und zwar über eine metallisierte Durchgangsöffnung (8), Leiterbahnen (10, 11) und ein zweites Anschlußkissen bzw. -fleck (7), und wobei der Chip (3) und das Plättchen (2) in einem Epoxyharz (1) verkapselt sind,
**dadurch gekennzeichnet**, daß
das Harz die Rand- bzw. Seitenkanten des Plättchens bedeckt und auf seiner gesamten Unterseite zwischen den Anschlußverbindungs-kügelchen (5) vorliegt und die auf der Ober- und der Unterseite des Plättchens befindlichen Leiterbahnen (10, 11) bedeckt, und daß die genannten metallisierten Öffnungen (8) mit Epoxyharz ausgefüllt sind.

2. Montagegehäuse für einen integrierten Schaltungschip nach Anspruch 1, dadurch gekennzeichnet, daß es unterhalb des Chips (3) metallisierte Durchgangsöffnungen bzw. -löcher aufweist.

3. Montagegehäuse für einen integrierten SchaltungsChip nach Anspruch 2, dadurch gekennzeichnet, daß die genannten unterhalb dem Chip (3) befindlichen metallisierten Öffnungen (8) vonder Oberseite her mit einem zur Befestigung des Chips (3) auf dem Plättchen (2) dienenden Kleber (4) und von der Unterseite her mit dem genannten Epoxyharz (1) ausgefüllt sind, und daß die auf der Oberseite des Plättchens (2) und unterhalb dem Chip (3) befindlichen Leiterbahnen (10) direkt mit dem genannten Kleber (4) bedeckt sind.

4. Verfahren zur Herstellung einer Gehäusekapselung für eine integrierte Schaltung, mit den folgenden Verfahrensstufen:
- Schaffung eines mit metallisierten Durchgangsöffnungen (8) zur Herstellung von Verbindungen zwischen seiner Ober- und seite versehenen Isolierstoff-Plättchens (2), wobei die Oberseite erste Anschlußkissen bzw. -flecken (6) zur Verbindung mit Anschlüssen eines integrierten Schaltungs-Chips (3) aufweist, die mit den genannten Durchgangsöffnungen über Leiterbahnen (10) verbunden sind, und wobei die Unterseite zweite Anschlußkissen bzw. -flecken (7) zur Verbindung mit Anschlußverbindungs- Kügelchen (5) aufweist, die mit den genannten Durchgangsöffnungen über zweite Leiterbahnen (11) verbunden sind;
- Aufbringen des integrierten Schaltungs-Chips (3) auf die Oberseite des Plättchens (2);
- Einbringen des Gebildes in eine Gießform zum Spritzgießen eines Kapselungsmaterials; sowie
- Einspritzen des Materials in die Form zur Kapselung des Chips und des Plättchens,
**dadurch gekennzeichnet**, daß
die Form so ausgebildet ist, daß sie die gesamte Unterseite des Plättchens (2) mit Ausnahme der Zonen für die Aufnahme der Anschlußverbindungs-Kügelchen (5) überdeckt, derart daß das Kapselungsmaterial (1) die Seitenränder des Plättchens bedeckt und die auf der Oberseite des Plättchens und außerhalb der Projektion des Chips befindlichen Leiterbahnen (10) sowie die auf der Unterseite des Plättchens befindlichen Leiterbahnen (11) direkt überdeckt und die genannnten metallisierten Durchgangsöffnungen ausfüllt.

5. Verfahren zur Herstellung einer Gehäusekapselung für eine integrierte Schaltung, nach Anspruch 4, dadurch gekennzeichnet, daß das Verfahren die folgenden Verfahrensstufen umfaßt:
- Durchbohren des Plättchens (2) an den künftigen Stellen der metallisierten Öffnungen (8);
- Aufbringen einer Leiterschicht auf den beiden Oberflächen des Plättchens (2) gemäß einem Muster von Leiterbahnen (10, 11) und von mit den Öffnungen (8) verbundenen Anschlußverbindungskissen bzw. -flecken (6, 7);
- Verkleben des integrierten Schaltungs-Chips (3) auf der Oberseite des Plättchens, mit Hilfe einer isolierenden Kleberschicht (4);
- Herstellen der Verbindungen des Chips (3) mit den ersten Anschlußverbindungs-Kissen bzw. -flecken (6) auf der Oberseite des Plättchens (2), mit Hilfe von Leiterdrähten;
- Verkapseln mit einem Epoxyharz (1) mittels Formgießen, unter Definition von Zonen zur Abscheidung von Anschlußverbindungs-Kügelchen (5) auf dem Niveau der zweiten Anschlußverbindungs kissen bzw. -flecken (7), mit Hilfe von Einsätzen in der Form; sowie
- Abscheiden von Anschlußverbindungs-Kügelchen (5) auf der Unterseite des Plättchens (2), in den in der Epoxyschicht (1) durch die Einsätze auf dem Niveau der zweiten Anschlußverbindungs-Kissen bzw. -Flecken (7) vorgesehenen Öffnungen.

## Claims

1. A casing for mounting an integrated circuit chip (3) including an insulating plate (2), on the upper surface of which is placed the chip and the lower surface of which including an array of connection balls (5), each ball being connected to a first pad (6) for connection to a terminal of the chip which is disposed on the upper surface, through a metallized trough-hole (8), conductive tracks (10, 11) and a second connection pad (7), the chip (3) and the plate (2) being encapsulated in an epoxy resin (1), characterized in that the resin covers the edges of the plate and is present on the whole of its lower surface, between the connection balls (5), and covers directly the conductive tracks (10, 11) arranged on the upper and lower surfaces of the plate, and in that said metallized holes (8) are filled with the epoxy resin (1).

2. A casing for mounting an integrated circuit chip according to claim 1, characterized in that it includes metallized trough-holes (8) disposed under the chip (3).

3. A casing for mounting an integrated circuit chip according to claim 2, characterized in that said metallized holes (8) disposed under the chip (3) are filled, from the upper surface, with glue (4) for fixing said chip (3) to said plate (2) and, from the lower surface, with said epoxy resin (1), said conductive tracks (10) on the upper surface of the plate (2) and under the chip (3) being directly covered with said glue (4).

4. A process for fabricating an integrated circuit casing, including the following steps:
- providing an insulating plate (2) with metallized trough-holes (8) for establishing connections between upper and lower surfaces of the plate, the upper surface comprising first pads (6) for connection to terminals of an integrated circuit chip (3) and connected to said holes through first conductive tracks (10), and the lower surface comprising second pads (7) for connection of connection balls (5) and complected to said holes through second conductive tracks (11);
- disposing the integrated circuit chip (3) on the upper surface of the plate (2);
- disposing the structure in a mold for injecting an encapsulation material (1); and
- injecting some material into the mold so as to encapsulate the chip (3) and the plate (2),
characterized in that the mold is formed so as to cover the whole lower surface of the plate (2) except reception areas of the connection balls (5), the encapsulation material (1) covering the edges of the plate and directly covering the conductive tracks (10) arranged on the upper surface of the plate and outside the projection of the chip, as well as the conductive tracks (11) arranged on the lower surface of the plate, and filling said metallized holes.

5. A process for fabricating an integrated circuit casing according to claim 4, characterized in that it includes the following steps:
- drilling the plate (2) at locations where the metallized holes (8) will be subsequently formed;
- depositing a conductive layer on both surfaces of the plate (2), according to a pattern of connection tracks (10, 11) and pads (6, 7) connected to the holes (8);
- gluing the integrated circuit chip (3) on the upper surface of the plate (2), with a layer of insulating glue (4);
- connecting the chip (3) to the first pads (6) of the upper surface of the plate (2), with conductive wires (9);
- encapsulating with an epoxy resin (1) by molding while using inserts to define depositing areas for the connection balls (5) on the second pads (7); and
- depositing connection balls (5) on the lower surface of the plate (2), in the openings defined in the epoxy resin layer (1) by the inserts on the second pads (7).
